# EUROPEAN PATENT APPLICATION

(11) **EP 1 198 040 A1**
(43) Date of publication of application: **17.04.2002**
(21) Application number: 01306727.7
(22) Date of filing: 13.08.2001
(51) Int. Cl.: H01S 5/028

(54) **Optical devices including high reflectivity coatings**

(30) Priority: 29.09.2000 US 677007
(71) Applicant: Agere Systems Optoelectronics Guardian Corporation, Orlando, Florida 32819-8698 (US)
(72) Inventor: Wu, Ping, Warren, NJ 07059 (US); Theis, Christopher, Breinigsville, PA 18031 (US); Chakrabarti, Utpal Kumar, Allentown, Pennsylvania 18104 (US); Fox,G.Jacob, Allentown, Pennsylvania 18103 (US); Sullivan,Kevin J., New Tripoli, Pennsylvania 18066 (US)
(74) Representative: Perkins, Sarah

(57) **Abstract**

The invention is an optical device (10), a package including an optical device (10), and a method of forming an optical device (10) where the device (10) has at least one facet (13) coated with a high reflectivity material (15). The high reflectivity material (15) includes at least one layer of tantalum oxide and, preferably, at least one layer of silicon.

## Description

This invention relates to optical devices, such as semiconductor lasers, which include high reflectivity coatings on at least one facet.

Interest in optoelectronics technology has recently exploded due to the tremendous information handling capacity of optical networks. Such networks typically include a semiconductor laser for generating signal light, an optical fiber for transmitting the light and a photodetector for receiving and converting the light into an electrical signal. The networks also typically include optical amplifiers and passive components such as filters, lenses and wavelength division multiplexers.

The semiconductor lasers employed are typically Fabry-Perot (FP), Distributed Feedback (DFB), or Distributed Bragg Reflector (DBR) lasers. Such lasers usually include an output facet which is covered with an antireflection (AR) coating (a reflectivity of less than 0.3% is typically required for DFB and DBR lasers), and a back facet which is covered by a high reflectivity (HR) coating (ie, a reflectivity of at least 60%). Materials proposed for the output facet have included oxides of tantalum and aluminum, and Y₂O₂ stabilized ZrO₂ .(See, eg, U.S. Patent No. 4,749,255 issued to Chakrabarti et al, and U.S. Patent No. 5,802,091 issued to Chakrabarti et al.) Materials for the back facet have included alternate layers of silicon and Y₂O₂ stabilized ZrO₂.

High power lasers suitable for telecommunications are usually provided in hermetically sealed packages. Much less expensive laser packages can be made without hermetic sealing, but in such cases the laser facets are susceptible to damage from contaminants in the atmosphere. It is therefore desirable to provide coatings which not only alter the reflectivity of the facets, but also perform a passivation function. Such coatings have been proposed for the AR coating on the output facet (U.S. Patent No. 5,802,091 cited above), and some work has been done in providing HR coatings on the back facet which include a mixture of tantalum and aluminum oxides. The coating on the back facet usually needs to have a specific reflectivity in order to satisfy the performance requirements of the laser and permit some light to escape the back facet for monitoring functions. Therefore, for some devices, a mixture of tantalum and aluminum oxide gives too high a reflectivity for adequate yields.

The invention in one aspect is an optical device with at least one facet having a high reflectivity coating. The high reflectivity coating comprises at least one layer that consists essentially of tantalum oxide.

In accordance with another aspect, the invention is an optical device package comprising a non-hermetic housing and an optical device mounted therein, the device having at least one facet coated with a high reflectivity coating. The high reflectivity coating comprises at least one layer that consists of tantalum oxide.

In accordance with another aspect, the invention is a method of fabricating an optical device with at least one facet. A high reflectivity coating is deposited on the facet. The coating includes at least one layer consisting essentially of tantalum oxide and at least one layer comprising silicon.

These and other features of the invention are delineated in detail in the following description. In the drawing:
Fig 1 is a schematic view of a semiconductor optical device according to an embodiment of the invention; and
Fig 2 is a schematic view of apparatus which may be utilized to deposit coatings according to an embodiment of the invention.

It will be appreciated that, for purposes of illustration, these figures are not necessarily drawn to scale.

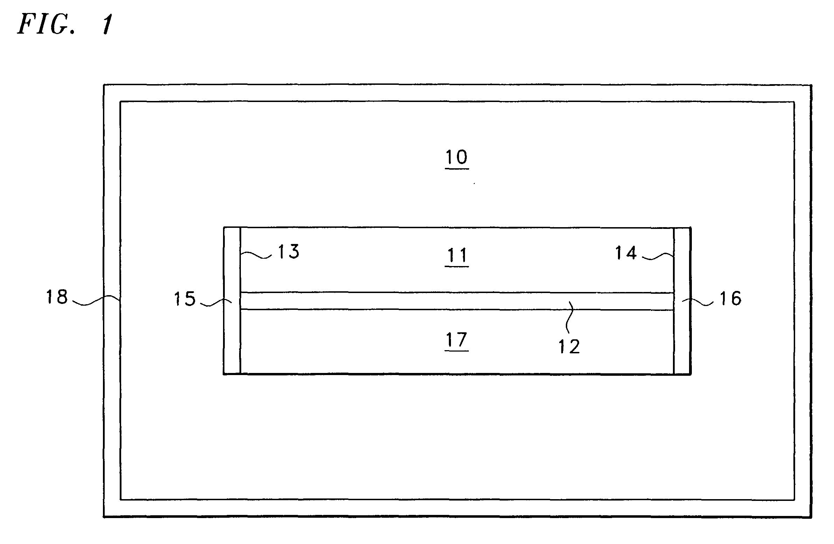

Fig 1 illustrates a device, 10, which includes inventive principles according to one embodiment. For purposes of discussion, it will be assumed that the device is a standard semiconductor laser such as a DFB of DBR laser. However, the invention is also applicable to other devices such as photodetectors which would utilize high reflectivity coatings.

The laser, 10, typically includes a plurality of semiconductor layers, eg, 11 and 12, formed on a semiconductor substrate, 17, such as InP. One of the layers is an active layer, 12, where light is generated. This layer is typically a plurality of alternating layers of a quantum well material and a barrier layer material, such as InGaAsP. Other layers, not specifically shown, include separate confinement layers, cladding layers, and current blocking layers. The layers are typically formed by Metal Organic Chemical Vapor Deposoition (MOCVD). Electrodes (not shown) are also deposited on the top and bottom surfaces in order to drive the laser.

The device, 10, is cleaved from a semiconductor wafer in order to form a front facet, 14, through which the laser light is output from the device, and a back facet, 13, through which a small amount of the generated light exits for purposes of monitoring the light. The front facet is coated in this example with an Anti-Reflecting (AR) coating using a dielectric material such as a mixture of Al₂O₃ and Ta₂O₅ which, preferably, will also passivate the front facet.

The back facet, 13, is coated with a high reflectivity coating, 15. Desirably, the coating, 15, has a reflectivity which produces high efficiency laser operation while permitting sufficient light through the back facet so that the light may be monitored. The preferred facet reflectivity is dependent on the design and performance requirements of the laser and the package it is in. Typically, the reflectivity is at least 60%, and in the range of 60% and 95%. For a given product, the rear facet reflectivity is typically required to be within a narrow range, e.g., 85% ± 3%. It is desirable to have the capability to adjust the coating reflectivity to meet the requirements of different semiconductor laser products. The laser, 10, is typically mounted within a package, illustrated schematically as housing 18. (Additional components such as an optical fiber, lenses, and driving and monitoring circuitry which are standard elements of the package are not shown.) It is further preferred that the coating, 15, protect the facet from contaminants in the atmosphere (ie perform a passivating function) so that the laser need not be packaged in a hermetic enclosure. Thus, the coating needs to be highly chemically stable.

Applicants have discovered that all these properties can be satisfied when the coating, 15, comprises at least one layer consisting essentially of tantalum oxide (Ta₂O₅) and preferably, at least one layer of silicon. In order to form a high reflectivity coating with dielectric material, it is typical to use alternating layers of high reflective index material and low refractive index material. The reflectivity can be increased by increasing the number of layers, or by increasing the difference in the refractive indices of the two materials. For example, when quarter-wave thickness layers are used, (i.e., thicknesses of 1585Å and 929Å, respectively, for Ta₂O₅ and Si layers, in the example of an InP based device working at a wavelength of 1.3 µm), a two-layer coating (laser/Ta₂O₅/Si) has a reflectivity of approx 65.3 percent. A four layer coating employing alternate layers of Ta₂O₅ and Si has a reflectivity of approximately 86.4 percent, and a six layer coating using the same material combination has a reflectivity of 95.1 percent. Although other dielectric layers such as Si0₂ and Al₂O₃ may be used together with tantalum oxide to form high/low refractive index pairs, with tantalum oxide being either the high index or the low index member, silicon is a preferred material because the large difference between the refractive index of silicon and that of tantalum oxide. Consequently fewer layers will be necessary to form coatings with any given high reflectivity requirement. This is advantageous both for ease of manufacturing and device reliability. For example, a six layer quarter-wave-thickness coating (at a wavelength of 1.3 µm), laser/SiO₂/Ta₂O₅/SiO₂/Ta₂O₅/SiO₂/Ta₂O₅, has a reflectivity of 85.1 percent, with a total thickness of 1.14 µm. In contrast, the earlier example of four layer laser/Ta₂O₅/Si/ Ta₂O₅/Si coating produces a reflectivity of 86.4 percent, with a total thickness of only 0.50 µm.

In general, the overall thickness of coating 15 is within the range of 0.2 to 1.0 µm. The index of refraction of the oxide layer is typically within the range 1.7 to 2.25, and most preferably 2.0 to 2.1, while the index of refraction of the silicon layer is typically within the range 3.4 to 3.85.

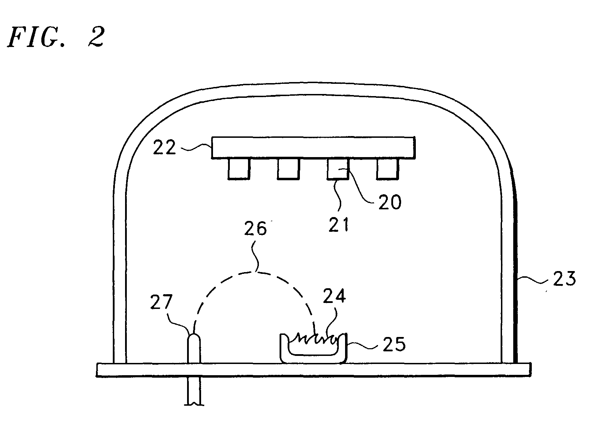

The layers of tantalum oxide and silicon are preferably deposited on the facet by electron-beam evaporation such as by the apparatus schematically illustrated in Fig 2. Devices, e.g., 20, are loaded into a holder, 22, such that the back facets, e.g., 21, are exposed. The holder is placed in a chamber, 23, which is evacuated to a pressure preferably lower than 3x10⁻⁶ Torr. Source material, 24, for the deposition is provided in a standard crucible, 25, placed in the chamber. An electron beam, 26, is provided by a source, 27, such as a filament and is incident on the source material, 24, in the crucible, 25. The electron beam causes evaporation of the source material which is then deposited on the exposed surfaces of the devices. Masks (not shown) can be provided on surfaces other than the back facets to prevent unwanted deposition on those surfaces.

For the deposition of tantalum oxide, the crucible, 25, is filled with pieces of sintered Ta₂O₅ and the evacuated chamber is back filled with oxygen to provide a pressure preferably within the range 1x10⁻⁵ to 9x10⁻⁵ Torr. A deposition rate of 1-10 angstoms per second is advantageous. For deposition of silicon, a different crucible filled with silicon is introduced and no oxygen backfill is employed. (Typically, the different crucibles are rotated into the path of the e-beam.) The deposition rate for silicon is advantageously 1-5 angstroms per second. For either layer, a temperature of 50 to 150 degrees C is preferred.

As known in the art, the reflectivity of the high reflectivity layer, 15, can be modified by altering temperature, pressure, and/or deposition rate. All of these conditions can affect the refractive index of the layer deposited and therefore affect the overall reflectivity of the coating. The use of an ion beam (not shown) directed to the facets to assist deposition may also be employed to alter reflectivity. (See, e.g., U.S. Patent No. 5,802,091 previously cited.)

Another method that may be used to adjust the reflectivity of the multilayer HR coatings is to deposit layers to a thickness other than the quarter-wave thickness. This would result in a coating having lower reflectivity than the quarter-wave thickness coatings having the same layer sequence. This method is less preferred than the refractive index adjustment as described above, because non-quarter-wave coatings have a spectrum response not as broad and as flat as quarter-wave coatings. In addition, higher overall process variation is associated with non-quarter-wave coatings.

## Claims

1. An optical device (10) with at least one facet (13) coated with a high reflectivity coating (15), the high reflectivity coating (15) comprising at least one layer consisting essentially of tantalum oxide.

2. An optical device package comprising a non-hermetic housing (18) and an optical device (10) mounted therein, the device (10) having at least one facet (13) coated with a high reflectivity coating (15), the high reflectivity coating (15) comprising at least one layer consisting essentially of tantalum oxide.

3. The device according to claim 1 or package according to claim 2 wherein the optical device (10) is a semiconductor laser comprising InP.

4. The device or package according to any one of the preceding claims wherein the reflectivity of the coating (15) is within the range 60% to 95%.

5. The device or package according to any one of the preceding claims wherein the thickness of the coating (15) lies within the range 0.2 µm to 1.0 µm.

6. The device or package according to any one of the preceding claims wherein the coating (15) further comprises a layer of silicon.

7. The device or package according to claim 6 wherein the index of refraction of the tantalum oxide layer is within the range 1.73 to 2.25, and the index of refraction of the silicon layer is within the range 3.4 to 3.85.

8. A method of fabricating an optical device (10) with at least one facet (13) comprising depositing a high reflectivity coating (15) on the facet (13), the coating (15) comprising at least one layer consisting essentially of tantalum oxide.

9. The method according to claim 8 wherein the coating (15) is deposited by electron beam evaporation.

10. The method according to claims 8 or 9 wherein the deposition is performed at a temperature of 50 to 150°C.

11. The method according to any of claims 8 to 10 wherein the coating (15) further comprises a layer of silicon.

12. The method according to claim 11 wherein the tantalum oxide is deposited at a rate of between 1-10 angstroms per second, and the silicon is deposited at a rate of 1-5 angstroms per second.

13. The method according to either claim 11 or 12 wherein the deposition is performed in an evacuated chamber, the tantalum oxide is deposited with an oxygen backfill such that the pressure is between 1-9x10⁻⁵ Torr, and the silicon is deposited without an oxygen backfill at a pressure of less than 3x10⁻⁶ Torr.
